Europäisches Patentamt

European Patent Office

Office européen des brevets

(11) Publication number: 0 257 300
A1

# EUROPEAN PATENT APPLICATION

(21) Application number: 87110547.4

(22) Date of filing: 21.07.87

(51) Int. Cl.4: **H01L 29/80** , H01L 29/205 , H01L 29/201

(30) Priority: 21.07.86 JP 171136/86

(43) Date of publication of application:
02.03.88 Bulletin 88/09

(84) Designated Contracting States:
DE FR GB NL

(71) Applicant: SUMITOMO ELECTRIC INDUSTRIES LIMITED
No. 15, Kitahama 5-chome Higashi-ku
Osaka-shi Osaka 541(JP)

(72) Inventor: Sasaki,Goro c/o Osaka Works
Sumitomo Electric Ind.Ltd. 1-3,Shimaya
1-chome
Konohana-ku Osaka-shi Osaka(JP)

(74) Representative: Lehn, Werner, Dipl.-Ing. et al
Hoffmann, Eitle & Partner Patentanwälte
Arabellastrasse 4
D-8000 München 81(DE)

(54) Field effect transistor.

(57) The invention provides a field effect transistor (FET) having an In P substrate (1) of semi-insulation material. A non-doped Ga In As layer (2) is epitaxially grown on the In p substrate (1). An n type Ga In As P layer (3) is epitaxially grown on the Ga In As layer (2). An Al in As layer (5) is formed directly or through another In P layer (4) on the Ga In As P (3) layer by epitaxial growth. A source electrode (6) and a drain electrode (7) are formed on the Al In As layer (5) with ohmic contacts, and a gate electrode (8) is formed on the Al In As layer (5) with a Schottky contact.

## Fig. 2

## FIELD EFFECT TRANSISTOR

BACKGROUND OF THE INVENTION

(a) Field of the Invention

The present invention relates to field effect transistors (FET). More specifically, the present invention provides a heterojunction type FET using two dimensional electron gas.

(b) Description of the Prior Art

Two general types of FETs are known. These general types are depletion type FETs and enhancement type FETs which have different threshold voltages.

In the depletion type FET, current flows between a source electrode and a drain electrode when the gate voltage is 0 volts. Drain current is controlled by applying a negative voltage to the gate. However, in the enhancement type FET, current does not flow when the gate voltage is 0 volts. Drain current is controlled by applying a positive voltage to the gate.

In the depletion type FET, since a negative voltage must be applied to the gate, a complicated power supply is necessary. When a plurality of depletion type FETs are serially coupled, it is necessary to provide a level shift circuit to to adjust the input and output voltages. Accordingly, enhancement type FETs are superior to the depletion type FETs from the point of view of power supply complexity.

However, heretofore, there have not been manufactured enhancement type FETs of the heterojunction type using two dimension electron gas. There have been proposed several kinds of heterojunction type FETS using two dimensional electron gas. For example, Japanese Patent Publication 53714/1984 discloses such an FET. FETs of this type are also disclosed in Japanese Journal of Applied Physics, page 225 of Vol. 19 1980 and in C. Y. Chen et al IEEE Electron Device Letters, page 152 of Vol. EDL 3, 1982.

The proposed FETs have either an Al Ga As/Ga As structure or an Al In As/Ga In As structure, wherein a Ga As thin layer or an Al Ga As layer are formed on a substrate by epitaxial growth. The substrate is made of semi-insulation material. The Ga As thin layer is non-doped. The Al Ga As layer is made of n type semiconductor that is n-type impurity doped. Electrons released from the Al Ga As impurity enter in the non-doped Ga As thin layer to provide the two dimensional electron gas.

A similar structure is in the Al In As/Ga In As FET. A mixed crystal semiconductor layer of GA In As is formed on a semi-insulating In P substrate and an Al In As mixed crystal semiconductor layer is formed on a Ga In As layer. They are formed by way of the epitaxial growth.

The electron affinity of the Ga In As layer is greater than that of the Al In As layer. The band gap of the Ga In As layer is narrower than that of the Al In As layer. The electrons released from the n impurity of the Al In As layer enter in the Ga In As as the carriers.

The impurity atoms that are positively charged remain in the Al In As layer. Thus, there acts coulomb force between the impurity atoms and the electrons in the Ga In As layer, whereby electrons are drawn toward the Al In As layer but are prevented from entering the Al In As layer. Accordingly, electrons become distributed in the two dimensional plane in the Ga In As layer near the interface which is generally referred to as the "heterojunction". The two dimensional electron gas near the heterojunction is separated from the impurity and the electrons can show high mobility with little impurity scattering. Thus, in FETs of the heterojunction type using two dimensional electron gas, a high transconductance with a high cut-off frequency can be obtained.

A problem inherent in conventional FETs using Al In As/Ga In As is that only depletion type FETs can be manufactured. As mentioned above, enhancement type FETs are superior to depletion type FETs in ease of construction of the power supply and bias circuit for a multi stage amplifier employing them. Accordingly, it is desirable to be able to manufacture enhancement type FETs.

In a FETs using two dimensional electron gas at the heterojunction, the threshold voltage Vth can be expressed as $\quad Vth = \phi_b -(q\, N_D/2\, \epsilon)\, d^2 -\Delta Ec \quad (1)$
wherein $\phi_b$ is a Barrier height and q is charge value of an electron (positive value), $N_D$ is donor concentration in the electron supply layer and d is a thickness of the electron supply layer. The electron supply layer refers to the n type Al In As layer. The reason why the coefficient of the term $N_D$ is 1/2 is that the n type impurities are distributed uniformly in the thickness direction. The coefficient may be calculated as desired by integrating a function, if the function of the distribution of the impurity in the thickness direction is already known. If the distribution of the impurity is uneven, there coefficient is not 1/2. $\Delta Ec$ is the conductive discontinuity in the heterojunction.

Assuming that $N_D$ is $1 \times 10^{18}$ cm$^{-3}$ and also assuming that d = 200 Å, the second term of the equation 1 amounts to about 0.3 volts. According, in the example shown, in order to make the threshold voltage positive (+), it is necessary that

$\phi b > \Delta Ec + 0.3$ volts     (2)

$\phi b$ can be defined corresponding to the material of the metal electrode, the semiconductor layer and the surface condition of the semiconductor layer.

For FETs using Al In As/Ga In As heterojunction, $\phi b$ is about 0.6 volts when the metal is made of aluminum. $\Delta Ec$ amounts to about 0.5 volts for the Al In As/Ga In As heterojunction. As a result, the right term becomes greater than the left term and the equation (2) cannot be satisfied. This is the reason why Vth is negative and only depletion FETs can be manufactured.

## SUMMARY OF THE INVENTION

Therefore, the present invention provides an enhancement type FET using two dimensional electron gas in the heterojunction of the Al In As and a mixed crystal semiconductor layer. It uses multi-layer heterojunction of

(1) Al In As/Ga In As P/Ga In As or

(2) Al In As/In P/Ga In As P/Ga In As.

The substrate is In P. The FET according to the present invention, has a gate electrode in contact with the Al In As layer by using a Schottky junction.

This arrangement is substantially the same structure as used in a conventional FET, wherein $\phi b$ is 0.6 volts for an Aluminum metal electrode. However, $\Delta Ec$ is within a range of 0 to 0.3 volts by using a quadrature mixed crystal of Ga In As P so that the inequality (2) can be satisfied and it is possible to make the threshold voltage Vth, to form an enhancement type heterojunction FET.

The structure of Ga In As which matches the In P substrate is expressed as

$Ga_{0.47x} In_{1-0.47x} As_x P_{1-x}$     (3)

where x is a parameter indicative of the composition ratio.

When x = 1, the structure is the mixed crystal of Ga In As which matches with In P substrate. The composition ratio of Ga and In which are both group III elements and the composition ratio of As and P which are group IV elements are parameters that are independently selectable. However, when a lattice matching is required for the respective layers with a specific substrate, there is required a predetermined relation between the respective parameters, so that the independent parameter is only one. Therefore, the equation (3) has only one independent parameter with respect to the composition ratio. When it is required to lattice match, there is a limitation of the composition ratio of Ga In As P shown in the equation (3) in which the suffix is omitted for brevity.

The band gap Eg for the quadrature mixed crystal as shown in the equation (3), an approximate equation (4) is given.

$Eg = 0.75 (1-x) + 1.35 x$ (eV)     (4)

The band gap Eg can be defined by defining the composition ratio parameter x.

To the contrary, when the band gap Eg is defined, the composition ratio parameter x can be defined. The composition ratio parameter x may be 0 to 1. Therefore, there may be used any one of the values of 0.75 eV to 1.35 eV as the desired band gap Eg. The heterojunction where the two dimensional electron gas exists is the junction of Ga In As P/Ga In As.

In case of intrinsic semiconductor with equal masses of electrons and holes, the Fermi level is at the center of the band gap. The Fermi level may be shifted from the center of the band gap if there are p or n impurities in the semiconductor layer or the mass of the electron and that of the positive hole are different. Since the parameters are already known or can be preliminarily defined, the level of the conductive band from the Fermi level can be calculated by giving the band gap Eg, composition ratio parameter and dope dosage of the n type impurity. Then, the conductive band discontinue $\Delta Ec$ at the heterojunction can be calculated. With x = 1, Eg is 1.35 eV in Ga In As. With x = 0, Eg is 0.75 eV in Ga In P.

3

The change of the level of the conduction band from the Fermi level may be considered to be half of the band gap Eg, although the change of the level depends on the amount of the amount of doping of the n type impurity in the Ga In As P layer. In case of a critical condition of x = 1, the difference of the band gap is 0, so that the conductive band discontinuity $\Delta Ec$ is also 0. To the contrary, in case of another critical condition of x = 0, since the difference of the band gap Eg is 0.6 eV, the conductive band discontinuity $\Delta Ec$ is about 0.3 eV.

As mentioned above, it is possible to change the conductive band discontinuity $\Delta Ec$ in a range from 0. to 0.3 eV in the Ga In As P/Ga In As heterojunction by changing the composition ratio x in the range of 1 to 0. In this range, the inequality (3) is available. Since the threshold value Vth is a positive value, it is possible to manufacture an enhancement type FET having a heterojunction structure.


BRIEF DESCRIPTION OF THE DRAWINGS

Fig. 1 is a cross sectional view of a preferred embodiment of a Ga In As P/Ga In As FET according to the present invention,

Fig. 2 is a cross-sectional view of another embodiment of a Ga In As P/Ga n As FET according to the present invention, and

Fig. 3 is a graph showing a relation between the band gap and distance from an interface of a Ga In As P/Ga In As heterojunction.


DETAILED DESCRIPTION OF THE PREFERRED EMBODIMENTS

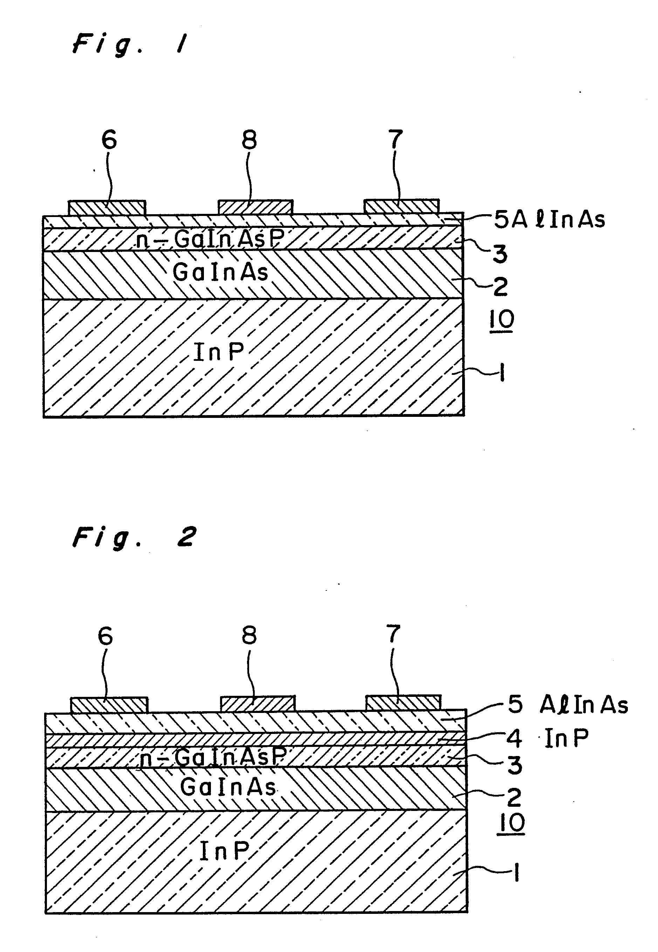

Fig. 1 is a cross sectional view of a preferred embodiment of a Ga In As P/Ga In As FET according to the present invention. There is shown a Ga In As P/Ga In As FET 10 having an In P substrate 1. Formed on the substrate 1 is a non-doped Ga In As layer 2 that is 0.1 to 0.3 $\mu$m thick. Formed on the Ga In As layer 2 is Ga In As P layer 3 doped with n type impurity. Formed on the Ga In As P layer 3 is a non-doped Al In As layer 5 that is 100 Å thick. Layers 2, 3 and 5 are formed by epitaxial growth. A source electrode 6, drain electrode 7 and gate electrode 8 are formed on the layer 5. The source electrode 6 and drain electrode 7 form an ohmic contact with the layer 5. Au Ge alloy is used as the source electrode 6 and drain electrode 7. The gate electrode 8, which is made of Al, contacts with the layer 5 in a Schottky contact.

The Al In As layer 5 may be doped with any impurity but preferably, the Al In As layer 5 is non-doped to improve the gate break voltage. The respective mixed crystals of the layers 2, 3, and 5 have a composition ratio matching with the composition ratio of the In P layer 1.

The Ga In As P layer 3 gives the electrons to the non-doped Ga In As layer 2. The n type Ga In As layer 3 defines the electron concentration. The thickness and impurity concentration of the layer 3 may be changed depending on the threshold voltage Vth according to equation (1). The thickness of the layer 3 is 200 Å and impurity concentration $N_D$ is $1 \times 10^{-18}$ / cm2.

By defining the values of the thickness and concentration as mentioned above, the second term of equation (1) is about 0.3 volts. When the thickness and concentration are increased over the values mentioned above, the amount of the second term of equation (1) is increased, whereby the second term of the right side of the inequality (2) is increased, resulting in limiting the conductive discontinuity $\Delta Ec$.

When the thickness and concentration are decreased from the values mentioned above, the range of the conductive discontinuity Ec satisfying the inequality (2) may be expanded. Decreasing the total amount of the n type impurity causes the number of the electron acting as the carrier to be decreased.

The composition ratio x may be uniform with reference to the thickness of the n type Ga In As P layer 3. In this case, since the composition ratio is uniform, the band gap Eg is constant. The band gap Eg is 1 eV, for example. Since the composition ratio is an independent parameter, it may be changed in the direction of the thickness of the layer 3. It is easy to change the respective composition ratios of the mixed crystal layers 2, 3, and 5 in the thickness direction, since they can be formed by MOCVD method or MBE method.

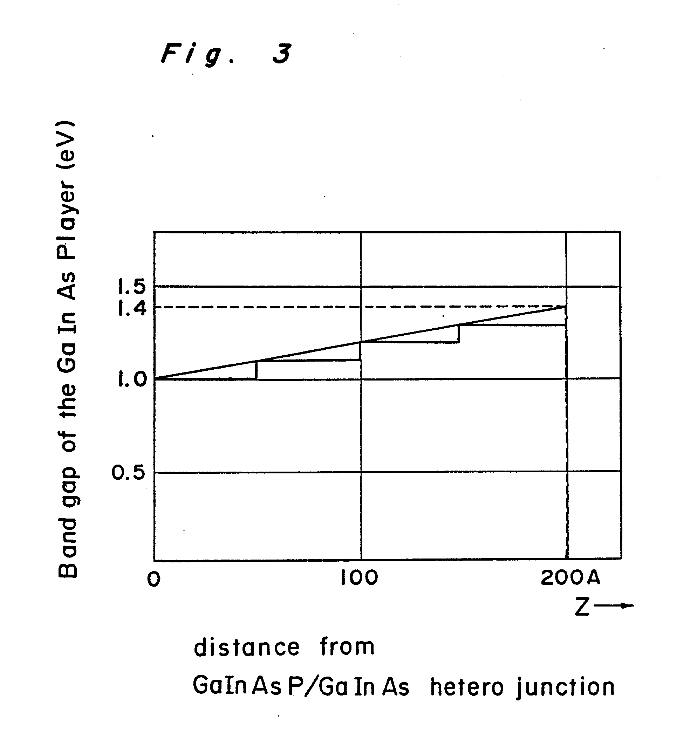

In the above-described embodiment, the composition ratio x in the Ga In As P layer 3 is changed stepwise in the thickness direction as shown in Fig. 3 in which the thickness direction is represented by z. Specifically, the band gaps are changed as shown in the Table I.

TABLE 1

| thickness z | band gap Eg | composition ratio x |
|---|---|---|
| 0 to 50 Å | 1 eV | 0.42 |
| 50 to 100 Å | 1.1 eV | 0.58 |
| 100 to 150 Å | 1.2 eV | 0.75 |
| 150 to 200 Å | 1.3 eV | 0.92 |

The composition ratios are changed holding the matching condition between the In P substrate 1 and Ga In As P layer 3. The value x is approximate value calculated by the equation (4) for every band gap Eg.

Fig. 2 shows another embodiment of the present invention in which a further In P layer 4 is formed between the Ga In As P layer 3 and Al In As layer 5 with about 100 Å thick. The In P layer 4 can be matched with the In P substrate 2. The In P layer 4 is non-doped but may be doped with suitable impurity.

An example of a way of the production of the Ga In As P/Ga In As FET will be explained. The non-doped Ga In As layer 2 which matches with the In P substrate 1 is formed on the In P substrate 1 with 0.1 to 0.3 μm thick by way of MOCVD method.

Subsequently, the Ga In As P layer 3 which matches with the In P substrate 1 and is doped with the n type impurity is formed on the Ga As In layer 2 with 200 Å thick and impurity concentration of $1 \times 10^{-18}$ cm$^{-3}$.

In case of the Fig. 2 example, In P layer 4 is formed on the layer 3 with 100 Å thick. This process is omitted when the example shown in Fig. 1 is made. Subsequently, the non-doped Al In As layer 5 is formed with 100 Å thick. Thereafter, the ohmic contact electrodes made of Au and Ge are formed on the layer 5 in suitable positions by way of vapor deposition, whereby the source electrode 6 and the drain electrode 7 are made by alloying. The gate electrode 8 is also made using Al by way of vapor deposition. Thus the present invention provides enhanced type FETs using the two dimension electron gas having a high electron mobility.

If the gate electrode made of aluminum is formed on the Al In As layer, the Schottky barrier $\phi b$ is about 0.6 volts. The second term of the equation (1) may be changed corresponding to the impurity concentration and thickness of the Ga In As P layer and the second term of the equation (1) amounts to about 0.3 volts.

In the equation (1), $\Delta Ec$ which is the conductive band discontinuity of the Ga In As P/Ga In As heterojunction changes corresponding to the composition ratio of Ga In As P mixed crystal. When the composition ratio x is 1, the conductive band discontinuity $\Delta Ec$ is 0.

To the contrary, in the case of x = 0, the mixed crystal is Ga In P and Eg is 0.75 eV and the difference of the band gap is 0.6 eV. The ratio between the difference of the band gap and the difference of the conductive band discontinuity is about 2, although it depends on the dose of the doping. Accordingly, in case of the critical condition of x = 0, the conductive band discontinuity $\Delta Ec$ amounts to about 0.3 eV. Thus, the equation (1) is positive within the range of x = 0 to 1. Since the Vth is positive, the FETs according to the present invention are enhancement type.

While this invention has been described in connection with what is presently considered to be the most practical and preferred embodiment, it is to be understood that the invention is not limited to the disclosed embodiment, but, on the contrary, is intended to cover various modifications and equivalent arrangements included within the spirit and scope of appended claims.

## Claims

1. A field effect transistor (FET) comprising:

an In P substrate (1) made of semi-insulating material;

a non-doped Ga In As layer (2) epitaxially grown on said In P substrate (1);

an n type Ga In As P layer (3) epitaxilly grown on the Ga In As layer (2):

an Al In As layer (5) formed on the Ga In As P layer (3) by epitaxial growth;

a source electrode (6) and a drain electrode (7) formed on the Al In As layer (5) with an ohmic contact; and a gate electrode (8) formed on the Al In As layer (5) in a Schottky contact.

2. A field effect transistor according to claim 1 wherein said Al In As layer (5) is formed through an additional In P layer (4) on the Ga In As P layer (3) by epitaxial growth;

3. The FET according to claim 1 or 2, wherein said gate electrode (8) is made of aluminum.

4. The FET according to claim 1 or 2, wherein a band gap $Eg$ of said transistor is changed stepwisely in the direction of the thickness by changing the composition ratio of the transistor in the direction of the thickness stepwisely.

*Fig. 1*

5 AlInAs
n-GaInAsP — 3
GaInAs — 2
10
InP — 1
6  8  7

*Fig. 2*

5 AlInAs
4 InP
n-GaInAsP — 3
GaInAs — 2
10
InP — 1
6  8  7

# Fig. 3

Band gap of the Ga In As P layer (eV)

1.5
1.4
1.0
0.5

0   100   200A

Z →

distance from
GaIn As P/Ga In As hetero junction

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| Y | EP-A-0 050 064  (THOMSON-CSF) * Page 2, lines 20-27; page 4, line 12 - page 5, line 6; figure 3 * | 1,3 | H 01 L  29/80 H 01 L  29/205 H 01 L  29/201 |
| A | --- | 2 | |
| Y | IEEE ELECTRON DEVICE LETTERS, vol. EDL-1, no. 8, August 1980, pages 154-155, IEEE, New York, US; H. OHNO et al.: "Double heterostructure Ga0.47In0.53As MESFETs by MBE" * Whole document * | 1,3 | |
| Y | IEEE TRANSACTIONS ON ELECTRON DEVICES, vol. ED-28, no. 1, January 1981, pages 1-5, IEEE, New York, US; H. MORKOC et al.: "Schottky barriers and ohmic contacts on n-type InP based compound semiconductors for microwave FET's" * Page 3, column 1, lines 19-33 * | 1,3 | |
| A | IDEM --- | 4 | **TECHNICAL FIELDS SEARCHED (Int. Cl.4)** |
| A | PATENT ABSTRACTS OF JAPAN, vol. 8, no. 217 (E-270)[1654], 4th October 1984; & JP-A-59 100 576 (FUJITSU K.K.) 09-06-1984 * Abstract; figures * --- | 1,2 | H 01 L |
| A | APPLIED PHYSICS LETTERS, vol. 38, no. 10, 15th May 1981, pages 817-819, American Institute of Physics, Woodbury, New York, US; S. BANDY et al.: "Saturation velocity determination for In0.53Ga0.47As field-effect transistors" * Page 818, column 1, lines 3-21; figure 1 * | 1,4 | |

--- -/-

The present search report has been drawn up for all claims

| Place of search | Date of completion of the search | Examiner |
|---|---|---|
| THE HAGUE | 26-11-1987 | MORVAN D.L.D. |

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| D,A | IEEE ELECTRON DEVICE LETTERS, vol. EDL-3, no. 6, June 1982, pages 152-155, IEEE, New York, US; C.Y. CHEN et al.: "Depletion mode modulation doped Al0.48In0.52As-Ga0.47In0.53As heterojunction field effect transistors" * Page 152, lines 1-5 from bottom; page 153, lines 1-5; figure 1 * | 1,3 | |
| | | | TECHNICAL FIELDS SEARCHED (Int. Cl.4) |

The present search report has been drawn up for all claims

| Place of search | Date of completion of the search | Examiner |
|---|---|---|
| THE HAGUE | 26-11-1987 | MORVAN D.L.D. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P0401)